# EUROPÄISCHE PATENTSCHRIFT

(11) **EP 2 033 268 B1**
(45) Veröffentlichungstag und Bekanntmachung des Hinweises auf die Patenterteilung: **20.06.2012**
(21) Anmeldenummer: 07764774.1
(22) Anmeldetag: 22.06.2007
(51) Int. Cl.: H01R 12/70, H01R 12/58

(54) **STECKVERBINDER AN EINEM BAUTEIL, DER IN EINEM LOCH EINER BASIS-PLATTE ZU BEFESTIGEN IST**
PLUG CONNECTOR ON A COMPONENT WHICH IS TO BE FIXED IN A HOLE OF A BASE-PLATE
CONNECTEUR ENFICHABLE SUR UNE PIÈCE DE CONSTRUCTION, QUI DOIT ÊTRE FIXÉ DANS UN TROU D'UNE PLAQUE DE BASE

(30) Priorität: 27.06.2006 DE 102006029381
(43) Veröffentlichungstag der Anmeldung: 11.03.2009
(73) Patentinhaber: William Prym GmbH & Co. KG, 52224 Stolberg (DE)
(72) Erfinder: SCHMITZ, Frank, 52391 Vettweiss (DE)
(74) Vertreter: Patentanwälte Buse, Mentzel, Ludewig
(86) Internationale Anmeldenummer: PCT/EP2007/005502
(87) Internationale Veröffentlichungsnummer: WO 2008/000391

(56) Entgegenhaltungen:
- EP-A2- 0 148 792
- EP-A2- 0 203 638
- US-A- 5 282 758
- US-A1- 2005 061 543
- US-A1- 2005 090 155

## Beschreibung

Die Erfindung richtet sich auf einen Steckverbinder, der im Oberbegriff des Anspruches 1 angegebenen Art. Der bekannte Steckverbinder ist aus dem Fachbuch "Einpresstechnik", Ralf Nolde, Eugen G. Leuze Verlag, 1994, Seite 56, Abb. 3.12 bekannt und in den Fig. 8 und 9 in einer Anwendung an einem Abschirmgehäuse gezeigt.

Weil der Steckverbinder einen Flachquerschnitt aufweist, lässt er sich schnell und preiswert als Stanzprodukt aus einem Blechmaterial herstellen. Der bekannte Steckverbinder besitzt ein Flachprofil mit einem verbreiterten Schaftabschnitt, der in seiner Längsmitte mit einem längsmittigen Durchbruch im Flachprofil versehen ist. Mittels des Durchbruchs wird der Schaftabschnitt des bekannten Steckverbinders in zwei zueinander spiegelbildlich gleich ausgebildete Schenkel gegliedert, die in der Ebene des Flachprofils gegeneinander federn. Wird der Steckverbinder in ein Loch einer Basis-Platte eingesteckt, so üben beide Schenkel eine Federkraft aus, die zu einer Klemmbefestigung des Steckverbinders im Loch der Platte führt. Das Schaftende ist linear ausgebildet und schlank. Das schlanke Schaftende passt ohne Verformung durch das Loch der Platte und ragt auf der Rückseite der Platte aus dem Loch heraus. Der bekannte Steckverbinder wird lediglich durch die erwähnte Klemmkraft in der Platte festgehalten. Es liegt lediglich eine kraftschlüssige Verbindung vor. Nach Überwinden der Klemmkraft kann der Steckverbinder ohne Weiteres wieder herausgezogen werden.

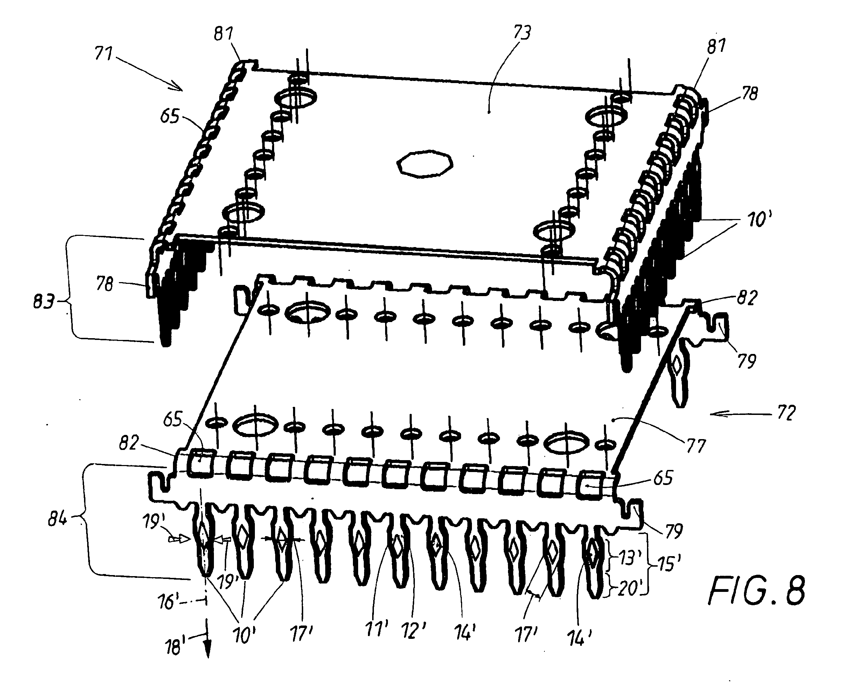

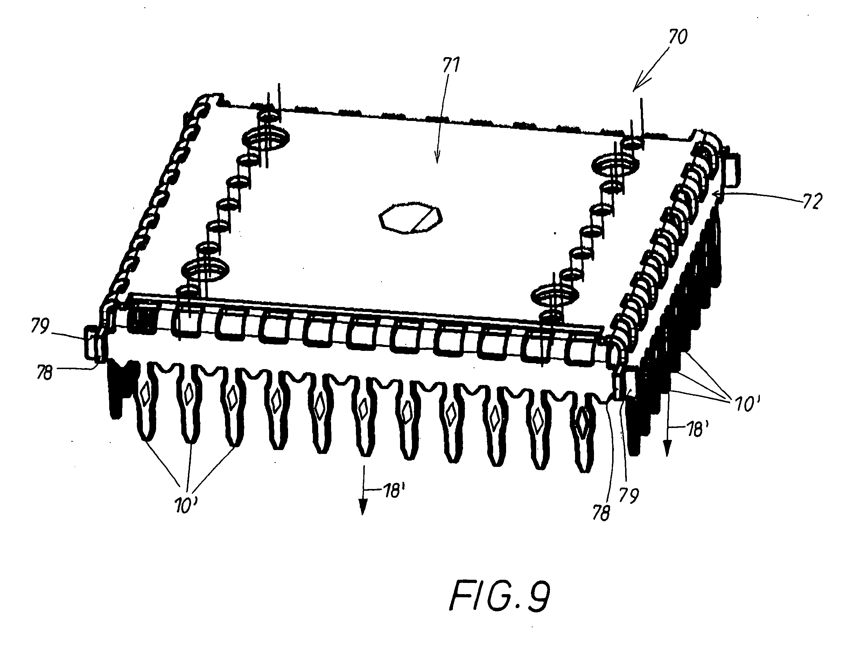

Wie bereits eingangs gesagt wurde, zeigen die Fig. 8 und 9 ein bekanntes Abschirmgehäuse, welches elektrische Bauteile überdecken soll, die auf einer Leiterplatte sitzen. Das bekannte fertige Gehäuse ist in Fig. 9 gezeigt, wo die Umfangsbereiche der Gehäuseseitenwände mit einer Vielzahl der vorgenannten Steckverbinder versehen sind. Diese bekannten Steckverbinder sind einstückig mit Gehäuseteilen ausgebildet und verlaufen in Verlängerung der Seitenwände vom Gehäuse, weil auch das Gehäuse als Stanzprodukt aus einem Blechmaterial gebildet ist. Der Nachteil ist, dass das Gehäuse aus zwei einander ergänzenden Gehäuseteilen hergestellt werden muss, die in Fig. 8 in Explosionsdarstellung gezeigt sind. Der eine Gehäuseteil erzeugt die vordere und die hintere Seitenwand des späteren Gesamtgehäuses von Fig. 9, während der andere Gehäuseteil die linke und rechte Seitenwand mit zugehörigen Steckverbindern ausbildet.

Es versteht sich, dass solche Steckverbinder auch an anderen Bauteilen angeordnet sein könnten, die in einem Loch einer Basis-Platte befestigt werden sollen. Wie bereits gesagt wurde, lassen sich die bekannten Steckverbinder mit Flachprofil als Stanzprodukt zwar sehr preiswert herstellen, haben aber den Nachteil, dass sie nicht zuverlässig im Loch sitzen.

Die FR 2 763 751 zeigt einen Steckverbindung anderer Art. Dort ist der Schaft verkröpft und besitzt einen Einschnitt, der inmitten des Schaftes eine aus der Schaftebene herausragende Zunge entstehen lässt. Während das Zungenende in einer ersten Ebene liegt, verbleiben beidseitig des Einschnitts zwei Arme im Schaft, die in einer anderen Ebene liegen. Die Zunge federt gegenüber der Ebene der beiden Arme. Eine in der Ebene der beiden Arme liegende Verbreiterung, die einen hinterschnittenen Kopf erzeugen könnte, ist nicht vorgesehen. Ein Herausziehen dieses bekannten Steckverbinders aus einem Loch in einer Basisplatte ist ohne Weiteres möglich.

Die EP 0 203 638 A2 zeigt einen Steckverbinder nach dem Oberbegriff des Anspruchs 1 mit einem gegabelten Schaft, der beidseitig eines profilierten Gabelschlitzes zwei Gabelzinken besitzt. Im Einsteckfall ragen die beiden Enden der Gabelzinken aus dem Loch einer Basisplatte heraus. Wegen der Profilierung des Gabelschlitzes werden dabei die Zinkenenden voneinander weggespreizt und hintergreifen das Loch.

Der Erfindung liegt die Aufgabe zugrunde, einen preiswerten Steckverbinder der im Oberbegriff des Anspruches 1 genannten Art zu entwickeln, der bequem zu handhaben ist und sich durch eine hohe Einstecksicherheit in der Basis-Platte auszeichnet. Dies wird erfindungsgemäß durch die in Anspruch 1 erwähnten Maßnahmen erreicht, denen folgende besondere Bedeutung zukommt.

Bei der Erfindung werden die beiden Schenkel im verbreiterten Schaftabschnitt zueinander unterschiedlich ausgebildet. Bezogen auf ihre Längserstreckung hat der eine Schenkel eine größere Schenkellänge als der andere, weshalb sie als "langer Schenkel" einerseits und "kurzer Schenkel" andererseits bezeichnet werden können. Deswegen verhält sich der lange Schenkel beim Einstecken in das Loch der Platte anders, als der kurze. Dies wird bei der Erfindung dazu genutzt, um einen am Schaftende sitzenden hinterschnittenen Kopf in der letzten Phase des Einsteckvorgangs quer zur Einsteckrichtung zu bewegen. Während der Anfangsphase der Durchsteckbewegung fluchtet der Kopf mit dem Öffnungsquerschnitt des Lochs, weshalb der Kopf die Einsteckbewegung nicht behindert. Der Kopf hat eine Kopfbreite, die kleiner/gleich dem Lochquerschnitt ausgebildet ist. Wenn aber der Kopf auf der Rückseite der Platte wieder heraustritt, sorgt das Zusammenspiel zwischen dem langen und dem kurzen Schenkel dafür, dass die erwähnte Querbewegung des Kopfs eintritt. Dadurch hintergreift der Kopf im Einsteckfall eine Kante von der Platte, die das Loch begrenzt. Ein Herausziehen des Steckverbinders aus der Basis-Platte ist dann nicht ohne Weiteres möglich. Der erfindungsgemäße Steckverbinder ist also im Loch der Platte formschlüssig gesichert.

Weitere Maßnahmen und Vorteile der Erfindung ergeben sich zunächst aus den Unteransprüchen 2 bis 14. Ein wichtiger Anwendungsfall eines solchen Steckverbinders ist in Anspruch 15 vermerkt.

In den Zeichnungen ist die Erfindung in zwei Ausführungsbeispielen dargestellt. Es zeigen:

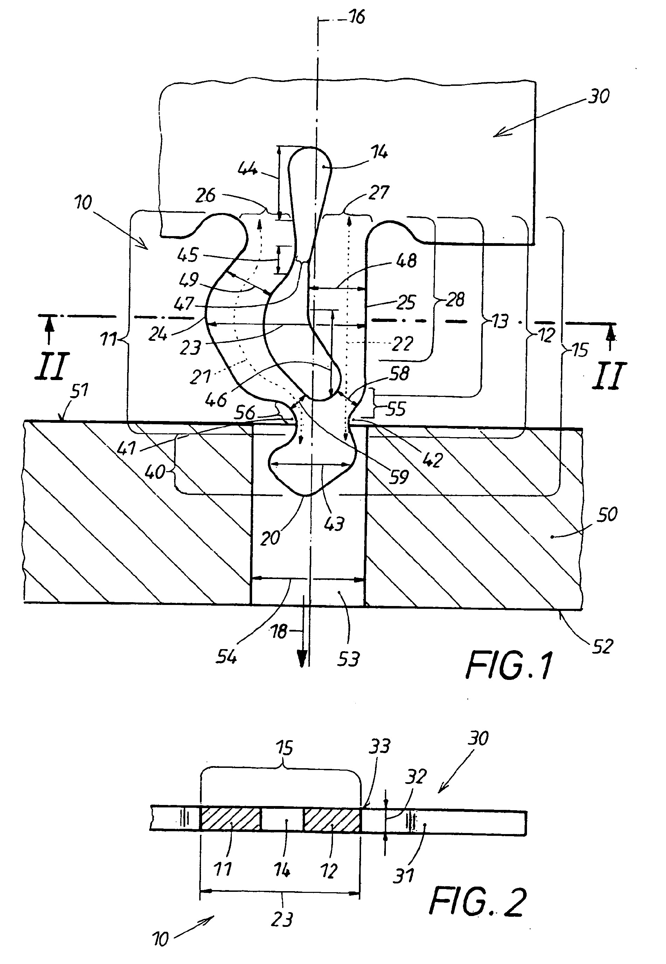

- Fig. 1: in Vergrößerung eine Seitenansicht auf einen erfindungsgemäßen Steckverbinder, der an einem beliebigen ersten Bauteil angeformt ist,
- Fig. 2: einen Querschnitt durch den Steckverbinder von Fig. 1 längs der dortigen Schnittlinie Ia - Ia, aus welcher der Flachquerschnitt seines Schafts zu erkennen ist,

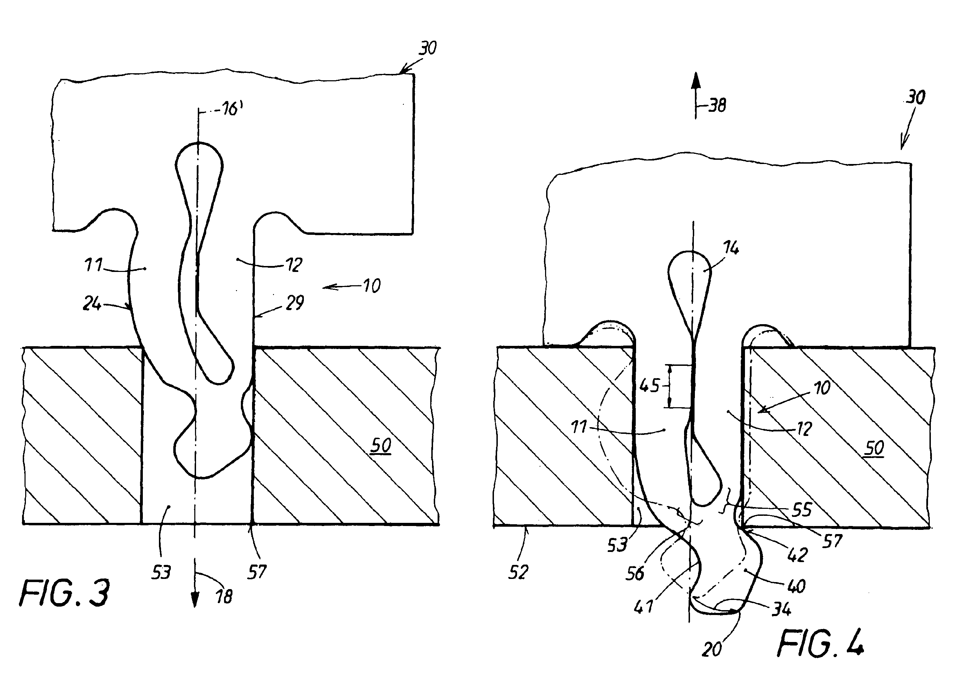

- Fig. 3: eine erste Phase der Einsteckbewegung des Steckverbinders in ein Loch einer Basis-Platte,
- Fig. 4: in einer zu Fig. 1 und 3 analogen Darstellung den Einsteckfall des erfindungsgemäßen Steckverbinders,

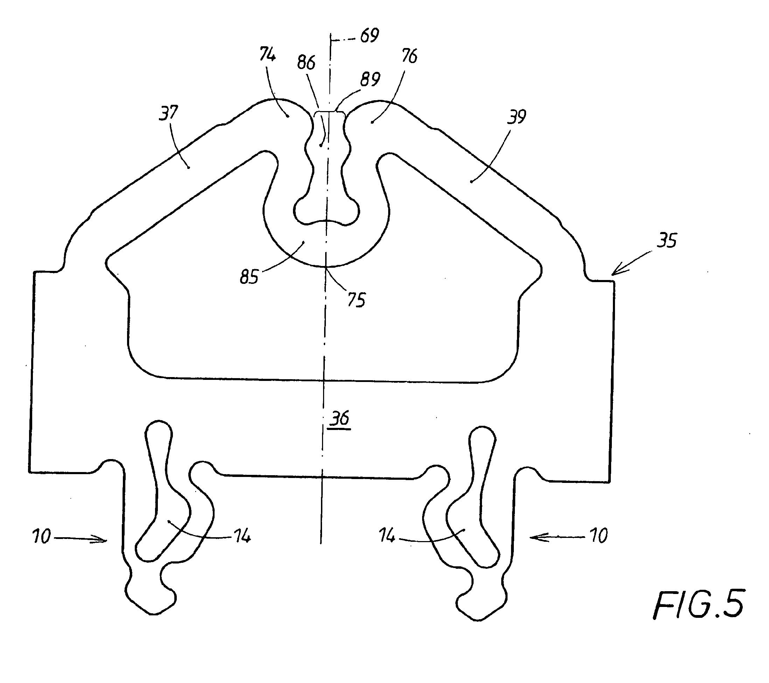

- Fig. 5: die Anwendung des erfindungsgemäßen Steckverbinders in doppelter Ausführung an einem zweiten Bauteil, der als Befestiger für einen beliebigen Funktionsteil verwendet werden kann und zwar im Ruhefall, d.h. bei demontiertem Befestiger,

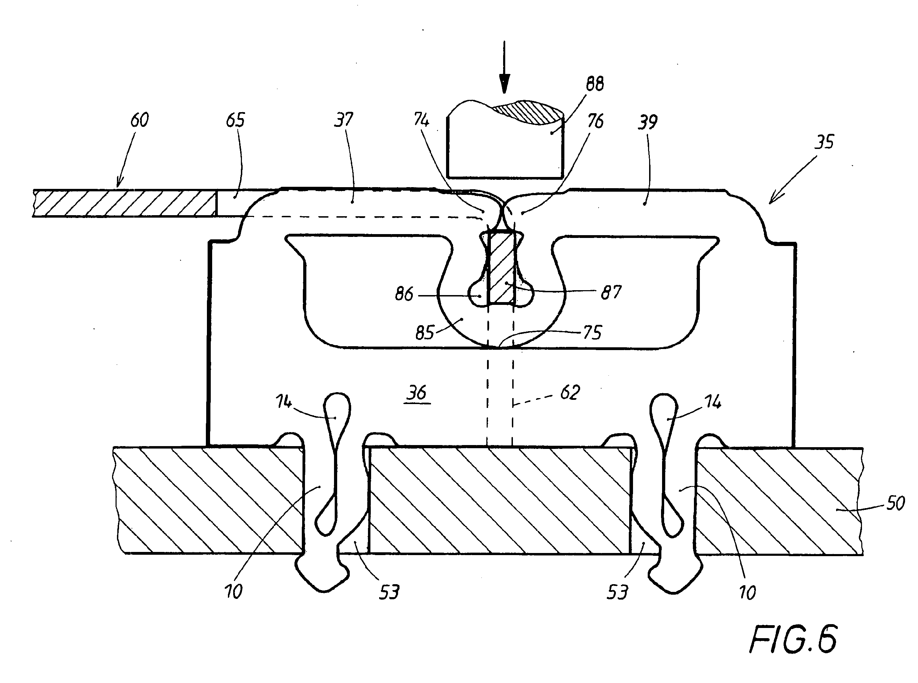

- Fig. 6: einen Anwendungsfall des Befestigers von Fig. 5, wo ein Funktionsteil mittels des Befestigers an einer Leiterplatte montiert ist und der Funktionsteil im dargestellten Ausführungsbeispiel aus einem gegenüber Fig. 8 und 9 einfacheren Abschirmgehäuse besteht und

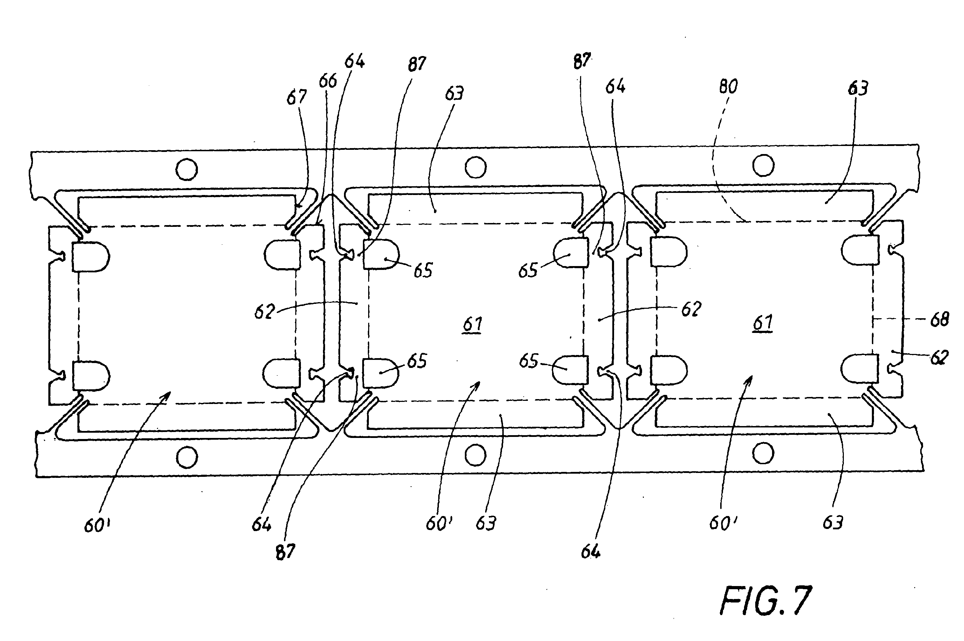

- Fig. 7: eine Vorstufe zur Herstellung des Abschirmgehäuses von Fig. 6, wo mehrere Gehäuse-Vorprodukte in einem Blechstreifen ausgestanzt sind und nur noch vereinzelt sowie randseitig umgebogen zu werden brauchen.

Wie bereits erwähnt wurde, zeigen die Fig. 8 und 9 den Stand der Technik. Zur Unterscheidung des erfindungsgemäßen Steckverbinders und seiner Anwendung werden dabei, soweit es sich um analoge Bauteile handelt, die gleichen Bezugszeichen wie bei der später zu beschreibenden Erfindung benutzt, zur Unterscheidung davon aber mit einem Strich (') versehen. Es zeigen:
- Fig. 8: in der bereits erwähnten Explosionsdarstellung und perspektivisch die beiden Gehäuseteile 71, 72, aus denen gemäß
- Fig. 9: ein Abschirmgehäuse 70 zusammengesetzt wird.

Jeder Gehäuseteil 71, 72 besteht aus einer eigenen Deckplatte 73, 77, die an gegenüberliegenden Enden mit abgewinkelten Randzonen 83 bzw. 84 versehen ist. Jeder Gehäuseteil 71, 72 besitzt also zwei Biegekanten 81 bzw. 82, die aber zueinander gegensinnig orientiert sind. Die Biegekante 81 des ersten Gehäuseteils 71 ist quer orientiert, während die Biegekante 82 des zweiten Gehäuseteils 72 längsorientiert verläuft. So besitzt der erste Gehäuseteil 71 ein U-förmiges Längsprofil und der Gehäuseteil 72 ein U-förmiges Querprofil.

Die Endbereiche der jeweiligen Randzonen 83, 84 sind mit einer Schar der bekannten Steckverbinder 10' versehen, die jeweils einen Schaft 15' aufweisen. Der Steckverbinder 10' ist bezüglich seiner strichpunktiert in Fig. 8 veranschaulichten Längsachse 16' in jeder Hinsicht symmetrisch ausgebildet. Es gibt einen verbreiterten Schaftabschnitt 13', der mit einem Durchbruch 14' versehen ist. Dieser Schaftabschnitt 13' besitzt eine gegenüber dem lichten Durchmesser eines nicht näher gezeigten Loches in einer Basis-Platte größere Schaftbreite 17'. Beidlängsseits des Durchbruchs 14' entstehen zwei zueinander spiegelbildlich gleich ausgebildete Schenkel 11', 12', die beim Einstecken 18' gemäß Fig. 8 im Sinne der Kraftpfeile 19 gegeneinander federn. Dem verbreiterten Schaftabschnitt 13' ist ein linearer schlanker Schaftendabschnitt 20' vorgeschaltet, dessen Schaftbreite kleiner/gleich der lichten Weite des Loches ist.

Zur Erleichterung der vorbeschriebenen Biegung 81, 82 sind bei den bekannten Gehäuseteilen 71, 72 von Fig. 8 eine Schar von Löchern 65 vorgesehen. Das fertige Gehäuse 70 von Fig. 9 wird durch Zusammenstecken der beiden Gehäuseteile 71, 72 von Fig. 8 zusammengebaut. Der Zusammenhalt der beiden Gehäuseteile 71, 72 wird durch komplementäre Ansätze 78, 79 erzielt, die als Klammer und Gegenklammer fungieren. Beim Zusammenbau der beiden Gehäuseteile werden die Klammern 78 und Gegenklammern 79 paarweise ineinandergesteckt. Wegen der beiden Gehäuseteile 71, 72 hat das Gesamtgehäuse 70 eine doppellagige Deckplatte 73, 77, was einen großen Materialaufwand begründet. Wegen der kraftschlüssigen Wirkung der bekannten Steckverbinder 18', müssen diese an allen Randbereichen des fertigen Gesamtgehäuses 70 in hoher Stückzahl vorgesehen sein, um durch Aufsummierung der dabei anfallenden zahlreichen Federkräfte 19' eine noch tolerierbare Verbindung des Gehäuses 70 an der Basis-Platte zu erhalten.

Die Erfindung geht in dieser Hinsicht einen ganz anderen, besseren Weg, was anhand des Steckverbinders von Fig. 1 bis 4 näher erläutert werden soll. Zur besseren Übersicht sollen zur Benennung analoger Bauteile am erfindungsgemäßen Steckverbinder 10, wie gesagt, weitgehend die gleichen Bezugszeichen wie in Fig. 8 und 9 benutzt werden, allerdings ohne Strich (').

Ausweislich der Fig. 1 ist der Steckverbinder 10 einstückig mit einem beliebigen Bauteil 30 ausgebildet, welches an einer Basis-Platte 50 befestigt werden soll. In der Basis-Platte 50 gibt es ein Loch 53, in welches der Steckverbinder 10 mit seinem Schaft 15 im Sinne des Pfeils 18 eingesteckt werden soll. Dazu wird die strichpunktierte Längsachse 16 vom Schaft 15 mit dem Loch 53 ausgerichtet. Der Schaft 15 hat einen Schaftabschnitt 13 mit einer gegenüber der lichten Weite 54 des Loches 53 vergrößerten Schenkelbreite 23. In diesem Bereich befindet sich zwar auch ein Schaft-Durchbruch 14, der bezüglich der Längsachse 16 nicht nur unsymmetrisch, sondern auch versetzt ist. Beidseitig des Durchbruchs 14 entstehen zwar auch zwei Schenkel 11, 12, doch sind auch diese zueinander sehr unterschiedlich ausgebildet.

Als gepunktete Strecken ist in Fig. 1 der jeweilige Längsverlauf 21, 22 der beiden Schenkel 11, 12 veranschaulicht. Dies entsteht, weil der eine Schenkel 11 eine Krümmung 24 aufweist, während der andere Schenkel 12 einen Streckverlauf 25 hat. Zwecks besserer Unterscheidung soll daher, entsprechend ihren unterschiedlichen Längenverhältnissen 21, 22 der eine Schenkel 21 als "langer Schenkel" und der andere 12 als "kurzer Schenkel" benannt werden. Beide Schenkel 11, 12 laufen an ihrem Schaftende 20 in einem Kopf 40 aus, der im Übergang zum langen Schenkel 21 und zum kurzen Schenkel 22 jeweils einen Hinterschnitt 41 bzw. 42 aufweist. Der Kopf 40 hat eine maximale Breite 43, die höchstens gleich der lichten Loch-Weite 54 ist. Der Kopf 20 behindert daher die Einsteckbewegung 18 ins Loch 53 nicht. Betrachtet man den gepunkteten Längsverlauf 21, so lässt sich im langen Schenkel 11 ein S-förmiger Verlauf feststellen.

Wie Fig. 2 veranschaulicht, besteht der Bauteil 30 mit dem Steckverbinder 10 aus dem Stanzprodukt eines Bleches 31. Der Schaft 15 hat daher im Querschnitt ein Flachprofil 33, dessen Profilhöhe der Blechstärke 32 von Fig. 2 entspricht. Im dargestellten Schnittbereich von Fig. 2 erkennt man gerade die maximale Schaftbreite 23 im Bereich des Krümmungsscheitels des langen Schenkels 11 mit dem dazwischen liegenden Stück des Durchbruchs 14 und dem Querschnitt vom kurzen Schenkel 12.

Der unsymmetrische Durchbruch 14 im Schaft 15 lässt sich in wenigstens drei Zonen 44 bis 46 gliedern. Es gibt eine Mittelzone 45, die eine Verengung 47 aufweist. Beidseitig dieser Mittelzone 45 besitzt der Durchbruch 14 eine obere Endzone 44 und eine untere Endzone 46, die erweitert sind. Die obere Endzone 44 erstreckt sich über die beiden Ansatzstellen 26, 27 der beiden Schenkel 11, 12 am Bauteil 30. Ausgehend von der Verengung 47 erweitert sich die obere Endzone 44 kontinuierlich bis zu ihrem Scheitelpunkt. Die untere Endzone 46 folgt weitgehend dem Krümmungsverlauf 24 des langen Schenkels und schneidet dabei sogar die Schaft-Längsachse 16. Ab einer gewissen Entfernung von der Verengung weist die untere Endzone 46 vom Durchbruch 14 eine kontinuierliche lichte Breite auf.

Die beschriebene Außenform der beiden Schenkel 11, 12 und der unsymmetrische Durchbruch 14 erzeugen am kurzen Schenkel 12 ein verbreitertes Schenkelstück 28. Die sich dabei ergebende Schenkelbreite 48 versteift den kurzen Schenkel 12. Dieses verbreiterte Schenkelstück 28 geht über einen hinsichtlich der Schenkelbreite 58 schmaleres Schenkelendstück 55 in den Kopf 40 über. Analoges gilt auch für den langen Schenkel 11. Dieser Schenkel 11 besitzt eine weitgehend gleichbleibende Schenkelbreite 49, doch auch diese geht in einem Schenkelendstück 56 mit einer verjüngten Schenkelbreite 59 in den Kopf 40 über.

Beim Einstecken 18 gemäß Fig. 2 stößt der lange Schenkel 11 gegen die eine Kante des Lochs 53, wodurch seine Krümmung 24 zur Schaftachse 16 hin gedrückt wird. Der kurze Schenkel 12 hat eine im Wesentlichen geradlinige Außenkante 29, die an der gegenüberliegenden Lochkante 57 entlang gleiten kann.

Der fertige Einsteckzustand ist in Fig. 4 gezeigt. Der Einsteckfall ist dadurch gekennzeichnet, dass der Kopf 40 auf der Platten-Rückseite 52 herausgetreten ist. Die beiden Schenkel 11, 12 sind soweit zusammengedrückt, dass in der Mittelzone 45 des Durchbruchs 14 gegenüberliegende Durchbruchskanten nahezu in Berührung miteinander gekommen sind. Der Ruhefall mit unverformten Schenkeln 11, 12 gemäß Fig. 1 ist in Fig. 4 strichpunktiert eingezeichnet. Wie Fig. 4 erkennen lässt, findet beim Übergang vom strichpunktierten Ruhefall in dem ausgezogen gezeichneten Einsteckfall auch eine Schwenkbewegung 34 des Kopfes 40 statt, wie durch einen Schwenkpfeil verdeutlicht ist. Die Folge ist, dass der Kopf 40 mit seinem Hinterschnitt 42 die Lochkante 57 hintergreift. Der am langen Schenkel 11 befindliche gegenüberliegende Hinterschnitt 41 nimmt im Einsteckfall von Fig. 4 einen gestreckteren Verlauf gegenüber dem strichpunktiert in Fig. 4 verdeutlichten Ruhefall von Fig. 1 an.

Diese Schwenkbewegung 34 des Kopfes 40 ist möglich, weil sowohl das schmale Schenkelendstück 55 des kurzen Schenkels 12 als auch das entsprechende schmale Endstück 56 am langen Schenkel 11 als Biegestellen fungieren. Im Einsteckfall von Fig. 4 verhindert der Hintergriff des Kopfes 40, dass der Steckverbinder 10 vom Bauteil 30 im Sinne des Pfeils 38 von Fig. 4 aus dem Loch 53 der Platte 50 herausgezogen werden kann. Es liegt ein Formschluss vor. Durch die erfindungsgemäße Ausbildung des Steckverbinders ist die Einstecklage des Bauteils 30 in der Platte 50 gesichert.

Die Fig. 5 und 6 zeigen einen Anwendungsfall des Steckverbinders 10. In diesem Fall besteht der Bauteil aus einem Befestiger 35. Der ganze Befestiger 35 wird als Stanzprodukt hergestellt und besitzt an der Unterkante seines Mittelstücks 36 zwei Steckverbinder 10 der vorbeschriebenen Art in zueinander spiegelbildlicher Anordnung. Der ganze Befestiger 35 ist zu einer längsmittigen strichpunktierten Symmetrieachse 69 spiegelbildlich gleich ausgebildet. Dies gilt auch hinsichtlich der an der oberen Kante des Mittelstücks 36 angeordneten beiden Klemmarmen 37, 39, die im Lösefall gemäß Fig. 5 einen Neigungsverlauf ihrer beiden freien Armenden 74, 76 aufweisen. Die beiden Armenden 74, 76 sind durch eine Schlaufe 85 miteinander verbunden, deren Schlaufeninnenraum 86 ein Nockenprofil aufweisen kann. Der Befestiger 35 dient dazu, ein beliebiges Funktionsteil, nämlich im vorliegenden Fall ein Abschirmgehäuse 60 an einer Leiterplatte 50 zu befestigen. Dies geschieht durch einen Steg 87, der am Abschirmgehäuse 60 in mehrfacher Anordnung vorgesehen ist. Die Form des Gehäuses 60 lässt sich am besten anhand der Fig. 7 beschreiben.

Fig. 7 zeigt ein Metallband, in welchem fortlaufend eine Schar von Vorprodukten 60' ausgestanzt wird, aus denen dann durch Heraustrennen und Biegen die eigentlichen Gehäuse 60 entstehen, von denen ein Teilstück in Fig. 6 gezeigt ist. Die Vorprodukte 60' werden abschnittweise aus dem Metallband herausgestanzt und stehen mit den Randstreifen des Metallbandes über noch durchzutrennende Metallbrücken in Verbindung. Bereits aus dem Vorprodukt 60' lässt sich die spätere Form des Gehäuses 60 erkennen.

Das spätere Gehäuse 60 hat, grob gesagt, eine Schalenform, die gewendet verwendet wird. Sie lässt sich gliedern in eine im Wesentlichen ebene Deckplatte 61, die von dem mittleren Bereich des in Fig. 7 erkennbaren Stanz-Vorprodukts 60' gebildet wird. Das Endprodukt 60 entsteht aus dem Vorprodukt 60, indem die Randstreifen 62, 63, welche um die Deckplatte 61 herumliegen, rechtwinkelig abgewinkelt werden. Dabei berühren sich gegenüberliegende Randstreifen-Kanten 66, 67. Die beiden Randstreifen 62, 63 haben zunächst einmal die übereinstimmende Funktion nach ihrer Abwinkelung die Seitenwände im fertigen Gehäuse 60 zu bilden. Das ist aus Fig. 5 zu erkennen. Darüber hinaus haben die Randstreifen 62 noch folgende weitere Funktion.

Am Übergang zwischen der Deckplatte 61 und dem Randstreifen 62 werden bereits im Stanz-Vorprodukt 60' Löcher 65 ausgestanzt. Ein oder zwei Löcher 65 im Übergangsbereich zu gegenüberliegenden Randstreifen 62 genügen. Die Randstreifen 62 sind in Ausrichtung mit den Löchern 65 auch noch mit Randeinschnitten 64 versehen, so dass zwischen ihnen der erwähnte Steg 87 entsteht. Wie Fig. 6 und 7 verdeutlichen, entstehen die Stege 87 kurz unterhalb der Knick-Kante 68 zwischen der Deckplatte 61 und dem Randstreifen 62. Weil diese Stege 87 aus dem Blechmaterial des Gehäuses 60 gebildet sind, haben sie Rechteckform. Wie gesagt, haben die Befestiger 35 im Gebrauchsfall die Aufgabe, das Gehäuse 60 an der Leiterplatte 50 zu befestigen. Dies geschieht, indem der Steg 87 gemäß Fig. 6 in folgender besonderer Weise im Schlaufeninneren 24' aufgenommen wird.

Beim Befestiger 87 ist das Schlaufeninnere 86 bereits im Ruhefall von Fig. 5 nicht glatt U-förmig ausgebildet, sondern profiliert. Es besitzt einander gegenüberliegende seitliche Nocken sowie einen bodenseitigen Nocken. Die Funktion dieser Nocken ist aus Fig. 6 zu entnehmen, wo der Befestigungsfall gezeigt ist. Dort ist das Arm-Paar 37, 39 durch ein Werkzeug 88 zusammengedrückt, und zwar soweit, dass die beiden Arme 37, 39 in Fig. 5 im Wesentlichen gestreckt verlaufen und daher einen Winkel von ca. 180° zwischen sich schließen. Das Zusammendrücken der beiden Schenkel 37, 39 kann dadurch begrenzt sein, dass der Schlaufen-Scheitel 75 gegen die Oberkante des Mittelstücks 36 stößt. Bei dieser Abflachung können die beiden federnden Enden 74, 76, wie Fig. 6 veranschaulicht, gegeneinander stoßen und dabei die Schlaufenöffnung 89 verschließen, also eine Null-Öffnung bilden. Vorausgehend, im Ruhefall von Fig. 5 ist die Schlaufenöffnung 92 ausreichend groß, um den Steg 87 einführen zu können. Ebenso ist in Fig. 4 der Schlaufen-Scheitel 75 noch in beträchtlichem Abstand vom Mittelstück 36 angeordnet.

Im Befestigungsfall von Fig. 6 ist der Steg 87 unverlierbar im Schlaufeninneren 86 gefangen. Für den Befestiger 35 wird nämlich ein Material verwendet, das in der Flachdrückposition der Armenden 74, 76 durch die Innenprofilierung festgehalten wird. Die beiden seitlichen Nocken im Schlaufeninneren 86 werden von gegenüberliegenden Seiten gegen das Flachprofil des Stegs 87 angedrückt gehalten, während die äußere Endfläche vom Steg 87 sich am bodenseitigen Nocken abstützt.

Wie Fig. 6 weiter zeigt, wird die innere Begrenzung des Stegs 87, die dem Loch zugekehrt ist, an den flachgedrückten Armenden 74, 76 zur Anlage gebracht. Wie ersichtlich, wird so der Steg 87 spielfrei im Schlaufeninneren 86 festgehalten.

Das Gehäuse 60 entsteht, wie Fig. 6 veranschaulicht, durch eine vierfache Abkantung, nämlich nicht nur des querverlaufenden Randstreifens 62 an der bereits erwähnten ersten Biege-Kante 68 gegenüber der Deckplatte 61, sondern auch gegenüber den längsverlaufenden Randstreifen 63. Dort entsteht eine zweite Biege-Kante 80 gemäß Fig. 7. Durch das Abkanten 68, 80 der Randbereiche 62, 63 erhält man aus dem Stanz-Vorprodukt 60' von Fig. 7 ein einstückiges, schalenförmiges Gehäuse 60, welches mit vier Befestigern 35 in der aus Fig. 5 ersichtlichen und bereits beschriebenen Weise an der Leiterplatte 50 befestigt werden kann. Das schalenförmige Gehäuse 60 ist gegenüber dem eingangs beschriebenen Stand der Technik materialsparender sowie einfacher ausgebildet und zeichnet sich durch eine schnelle Herstellung und wegen der erfindungsgemäßen Befestiger 35 durch eine bequemere Montage aus.

Der Befestiger 35 ist zwar ein gesonderter Bauteil gegenüber dem Gehäuse 60, erlaubt aber eine universelle Anwendbarkeit. Der erfindungsgemäße Befestiger 35 kann als Verbindungsmittel für Funktionsteile beliebiger Art an einer Basis 50 dienen. Zum Beispiel ist es ohne Weiteres möglich, schalenförmige Gehäuse 60, die eine größere oder kleinere Dimension aufweisen, mit dem gleichen Befestiger 35 an einer Basis 50 zu montieren.

### Bezugszeichenliste :

- 10': bekannter Steckverbinder (Fig. 8, 9)
- 11': bekannter erster Schenkel (Fig. 8)
- 12': bekannter zweiter Schenkel (Fig. 8)
- 13': bekannter verbreiteter Schaftabschnitt von 15' (Fig. 8)
- 14': bekannter Durchbruch in 13' (Fig. 8)
- 15': bekannter Schaft von 10' (Fig. 8)
- 16': bekannte Schaft-Längsachse von 15' (Fig. 8)
- 17': bekannte Schaftbreite bei 13' (Fig. 8)
- 18': bekannter Pfeil der Einsteckbewegung von 10' (Fig. 8)
- 19': bekannter Kraftpfeil der Federung von 11', 12' (Fig. 8)
- 20': bekannter linearer Schaftabschnitt von 15' (Fig. 8)
- 10: erfindungsgemäßer Steckverbinder (Fig. 1 bis 6)
- 11: langer Schenkel (Fig. 2 bis 4)
- 12: kurzer Schenkel (Fig. 2 bis 4)
- 13: verbreiteter Schaftabschnitt
- 14: Durchbruch in 13
- 15: Schaft
- 16: Längsachse von 15 (Fig. 1, 3 und 4)

- 18: Pfeil der Einsteckbewegung von 10

- 20: Schaftende von 15
- 21: Längsverlauf von 11 (Fig. 1)
- 22: Längsverlauf von 12 (Fig. 1)
- 23: maximale Schaftbreite von 13 (Fig. 1)
- 24: Krümmung von 11, Bogenverlauf (Fig. 1)
- 25: Streckverlauf von 12 (Fig. 1)
- 26: Ansatzstelle von 11 an 30 (Fig. 1)
- 27: Ansatzstelle von 12 an 30 (Fig. 1)
- 28: verbreitertes Schenkelstück von 12 (Fig. 1)
- 29: Außenkante von 12 (Fig. 3)
- 30: Bauteil (Fig. 1 bis 3)
- 31: Blech von 30 bzw. 10 (Fig. 2)
- 32: Blechstärke, Profilhöhe von 31
- 33: Flachprofil von 10 (Fig. 2)
- 34: Schwenkbewegung von 40 (Fig. 4)
- 35: Befestiger (Fig. 5, 6)
- 36: Mittelstück von 35 (Fig. 5)
- 37: erster Klemmarm an 35 (Fig. 5)
- 38: Pfeil einer Herausziehbewegung (Fig. 4)
- 39: zweiter Klemmarm an 35 (Fig. 5)
- 40: Kopf von 15 (Fig. 1)
- 41: Hinterschnitt von 40 gegenüber 11 (Fig. 1)
- 42: Hinterschnitt von 40 gegenüber 12 (Fig. 1)
- 43: maximale Kopfbreite von 40 (Fig. 1)
- 44: obere Endzone von 14 (Fig. 1)
- 45: Mittelzone von 14 (Fig. 1)
- 46: untere Endzone von 14 (Fig. 1)
- 47: Verengung von 14 in 45 (Fig. 1)
- 48: große Schenkelbreite von 28 (Fig. 1)
- 49: Schenkelbreite von 11 (Fig. 1)
- 50: Basis-Platte, Leiterplatte
- 51: Vorderseite von 50 (Fig. 1)
- 52: Rückseite von 50 (Fig. 1, 4)
- 53: Loch (Fig. 1, 3, 4 und 6)
- 54: lichte Lochweite von 53 (Fig. 1)
- 55: schmales Schenkelendstück von 12 (Fig. 1, 4)
- 56: schmales Endstück an 11 (Fig. 1, 4)
- 57: Lochkante von 53 (Fig. 3, 4)
- 58: Schenkelbreite von 55 (Fig. 1)
- 59: Schenkelbreite von 56 (Fig. 1)
- 60: Funktionsteil, Abschirmgehäuse (Fig. 6)
- 60': Stanz-Vorprodukt von 60 (Fig. 7)
- 61: Deckplatte von 60
- 62: querverlaufender Randstreifen von 60, 60' (Fig. 6, 7)
- 63: längsverlaufender Randstreifen von 60 (Fig. 7)
- 64: Randeinschnitt in 60, 60' (Fig. 6, 7)
- 65: Loch in 62 (Fig. 6, 7)
- 66: seitliche Endkante von 62 (Fig. 7)
- 67: seitliche Endkante von 63 (Fig. 7)
- 68: erste Biegekante zwischen 61, 62 (Fig. 6, 7)
- 69: Symmetrieachse von 35 (Fig. 5)
- 70: Gehäuse nach Stand der Technik (Fig. 9)
- 71: erster Gehäuseteil von 70 (Fig. 8, 9)
- 72: zweiter Gehäuseteil von 70 (Fig. 8, 9)
- 73: Deckplatte von 71 (Fig. 8)
- 74: freies Armende von 37 (Fig. 5, 6)
- 75: Scheitel von 20 (Fig. 5, 7)
- 76: freies Armende von 38 (Fig. 5, 7)
- 77: Deckplatte von 72 (Fig. 8)
- 78: Klammeransatz an 71 (Fig. 8)
- 79: Gegenklammer-Ansatz an 72 (Fig. 8)
- 80: zweite Biegekante zwischen 61, 63 (Fig. 7)
- 81: querverlaufende Biegekante bei 71 (Fig. 8)
- 82: längsverlaufende Biegekante bei 72 (Fig. 8)
- 83: Randzone von 71 (Fig. 8)
- 84: Randzone von 72 (Fig. 8)
- 85: Schlaufe zwischen 74, 76 (Fig. 5, 6)
- 86: Schlaufeninneres von 85 (Fig. 5, 6)
- 87: Steg an 60 (Fig. 6, 7)
- 88: Werkzeug (Fig. 6)
- 89: Schlaufenöffnung von 85 (Fig. 5)

## Patentansprüche

1. Steckverbinder (10) an einem Bauteil (30), der in einem Loch (53) einer Basis-Platte (50) befestigbar ist,
mit einem Schaft (15), der ein Flachprofil (33) aufweist und mit seinem Schaftende (20) im Einsteckfall auf der Platten-Rückseite (52) aus dem Loch (53) herausragt,
wobei dem Schaftende (20) ein gegenüber der Lochweite (54) verbreiteter Schaftabschnitt (13) folgt, der einen Durchbruch (14) in dem Flachprofil (33) besitzt,
und der Durchbruch (14) den Schaftabschnitt (13) in zwei Schenkel (11, 12) gliedert, die in der Ebene des Flachprofils (33) gegeneinander federn und im Einsteckfall den Schaft (15) im Loch (53) der Platte (50) festklemmen,
**dadurch gekennzeichnet,**
**dass** die beiden Schenkel (11, 12) zueinander unterschiedlich ausgebildet sind, der eine Schenkel (11) einen größeren Längsverlauf (21) als der andere (12) aufweist und daher dieser Schaftabschnitt (13) aus einem langen Schenkel (11) und einem kurzen Schenkel (12) besteht,
und **dass** das Schaftende (20) einen hinterschnittenen Kopf (40) besitzt, der im Einsteckfall eine das Loch (53) begrenzende Kante (57) von der Platte (50) hintergreift.

2. Steckverbinder nach Anspruch 1, **dadurch gekennzeichnet, dass** der lange Schenkel (11) gekrümmt ist, während der kurze Schenkel (12) im Wesentlichen gestreckt verläuft.

3. Steckverbinder nach Anspruch 1 oder 2, **dadurch gekennzeichnet, dass** der lange Schenkel (11) einen S-Verlauf aufweist.

4. Steckverbinder nach einem der Ansprüche 1 bis 3, **dadurch gekennzeichnet, dass** der Durchbruch (14) zwischen den beiden Schenkeln (11, 12) unsymmetrisch ausgebildet ist und der Krümmung des langen Schenkels (11) folgt.

5. Steckverbinder nach einem der Ansprüche 1 bis 4, **dadurch gekennzeichnet, dass** bereits im Ruhefall, d.h. bei demontiertem Steckverbinder (10), der Durchbruch (14) in seiner Mittelzone (45) eine Verengung (47) aufweist
und dass, ausgehend von der Verengung (47), der Durchbruch (14) beidendig, d.h. sowohl zum Kopf (40) hin als auch zum Bauteil (30) hin, erweiterte Endzonen (44, 46) besitzt.

6. Steckverbinder nach Anspruche 5, **dadurch gekennzeichnet, dass** die obere Endzone (44) vom Durchbruch (14) über die Ansatzstellen (26, 27) der beiden Schenkel (11, 12) hinaus sich in den Bauteil (30) hinein erstreckt.

7. Steckverbinder nach einem der Ansprüche 4 bis 6, **dadurch gekennzeichnet, dass** die unterhalb der Durchbruchs-Verengung (47) liegende Zone (46) vom Durchbruch (14) dem Krümmungsverlauf des langen Schenkels (11) im Wesentlichen folgt.

8. Steckverbinder nach einem der Ansprüche 1 bis 7, **dadurch gekennzeichnet, dass** der kurze Schenkel (12) ein verbreitertes Schenkelstück (28) besitzt, welches hinsichtlich der Schenkelbreite (48) größer ausgebildet ist und den kurzen Schenkel (12) versteift.

9. Steckverbinder nach Anspruch 8, **dadurch gekennzeichnet, dass** zwischen dem verbreiterten Schenkelstück (28) und dem Kopf (40) am Schaftende (20) ein hinsichtlich der Schenkelbreite (58) schmaleres Schenkelendstück (55) angeordnet ist.

10. Steckverbinder nach Anspruch 9, **dadurch gekennzeichnet, dass** beim Übergang zwischen dem Ruhefall in den Einsteckfall das schmale Schenkelendstück (55) als Biegestelle für den Kopf (40) am Schaftende (20) dient.

11. Steckverbinder nach einem der Ansprüche 1 bis 10, **dadurch gekennzeichnet, dass** der lange Schenkel (11) eine im Wesentlichen gleichbleibende Schenkelbreite (49) aufweist, aber im Übergang zum endseitigen Kopf (40) ein schmales Schenkelendstück (56) besitzt.

12. Steckverbinder nach Anspruch 11, **dadurch gekennzeichnet, dass** beim Übergang zwischen dem Ruhefall und dem Einsteckfall auch das schmale Schenkelendstück (56) des langen Schenkels (11) als Biegestelle für den endseitigen Kopf (40) fungiert.

13. Steckverbinder nach einem der Ansprüche 1 bis 12, **dadurch gekennzeichnet, dass** - im Ruhefall gesehen - ein Hinterschnitt (42, 41) am endseitigen Kopf (40) des Schafts (15) nicht nur beim kurzen Schenkel (12), sondern auch beim langen Schenkel (11) vorgesehen ist.

14. Steckverbinder nach Anspruch 12, **dadurch gekennzeichnet, dass** der Hinterschnitt (41) des Kopfs (40) am langen Schenkel (11) im Einsteckfall einen gestreckteren Verlauf einnimmt, als im Ruhefall.

15. Steckverbinder nach einem der Ansprüche 1 bis 14, **dadurch gekennzeichnet, dass** der Bauteil ein Befestiger (35) für einen davon getrennten Funktionsteil (60) ist.

## Claims

1. Plug connection (10) on a component (30) which is to be fixed in a hole (53) of a base-plate (50),
with a shaft (15) exhibiting a flat profile (33) and with its shaft end (20), when inserted on the plate-back (52), protruding from the hole (53),
whereby following the shaft end (20) and opposite the size of hole (54) is a widened shaft section (13) which has a breakthrough (14) in the flat profile (33),
and the breakthrough (14) divides the shaft section (13) into two blades (11, 12) which spring against each other in the level of the flat profile (33) and when inserted clamp the shaft (15) in the hole (53) of the plate (50),
thereby **characterized,**
**in that** both blades (11, 12) are designed differently towards one another, one blade (11) having a greater longitudinal run (21) than the other (12) and for this reason this shaft section (13) comprises a long blade (11) and a short blade (12),
and **in that** the shaft end (20) has an undercut head (40) which when inserted grips behind an edge (57) of the plate (50) bordering the hole (53).

2. Plug connection pursuant to Claim 1, thereby **characterized in that** the long blade (11) is curved, while the short blade (12) essentially has a stretched run.

3. Plug connection pursuant to Claim 1 or 2, thereby **characterized in that** the long blade (11) exhibits an S-run.

4. Plug connection pursuant to one of the claims 1 to 3, thereby **characterized in that** the breakthrough (14) between both blades (11, 12) is asymmetrical in form and follows the curve of the long blade (11).

5. Plug connection pursuant to one of the claims 1 to 4, thereby **characterized in that** already when inactive, i.e., when the plug connection (10) is in a detached state, the breakthrough (14) exhibits a narrowing (47) in its middle zone (45),
and **in that**, based on the narrowing (47), the breakthrough (14) has on both ends, i.e.. towards the head (40) as well as towards the component (30), extended end zones (44,46).

6. Plug connection pursuant to Claim 5, thereby **characterized in that** the upper end zone (44) of the breakthrough (14) stretches beyond the insertion points (26, 27) of both blades (11, 12) into the component (30).

7. Plug connection pursuant to one of the claims 4 to 6, thereby **characterized in that** the zone (46) of the breakthrough (14) lying under the breakthrough narrowing (47) essentially follows the curve run of the long blade (11).

8. Plug connection pursuant to one of the claims 1 to 7, thereby **characterized in that** the short blade (12) has a widened blade section (28) which with regard to the blade width (48) is larger in form and stiffens the short blade (12).

9. Plug connection pursuant to Claim 8, thereby **characterized in that** arranged between the widened blade section (28) and the head (40) at the shaft end (20) is, with respect to the blade width (58), a narrower blade end piece (55).

10. Plug connection pursuant to Claim 9, thereby **characterized in that** upon transition from inactivity to insertion, the narrow blade end piece (55) acts as a bending point for the head (40) on the shaft end (20).

11. Plug connection pursuant to one of the claims 1 to 10, thereby **characterized in that** the long blade (11) has an essentially uniform blade width (49), but upon transition to the head (40) at the end, has a narrow blade end piece (56).

12. Plug connection pursuant to Claim 11, thereby **characterized in that** upon transition from inactivity to insertion, also the narrow blade end piece (56) of the long blade (11) acts as a bending point for the head (40) at the end.

13. Plug connection pursuant to one of the claims 1 to 12, thereby **characterized in that** - based on the inactive state - an undercut (42, 41) on the head (40) at the end of the shaft (15) is provided not only for the short blade (12), but also for the long blade (11).

14. Plug connection pursuant to Claim 12, thereby **characterized in that** the undercut (41) of the head (40) on the long blade (11) assumes a more extended run upon insertion than when inactive.

15. Plug connection pursuant to one of the claims 1 to 14. thereby **characterized in that** the component is a fastener (35) for a functioning part (60) which is separate therefrom.

## Revendications

1. Connecteur enfichable (10) sur un composant (30), pouvant être fixé dans un trou (53) d'une plaque de base (50),
avec une tige (15) présentant un profil plat (33) et dont l'extrémité (20) de tige fait saillie, à l'état enfiché, hors du trou (53) au dos (52) de la plaque,
sachant que l'extrémité (20) de tige est suivie d'un segment (13) de tige plus large que le calibre (54) du trou, segment qui comporte une orifice traversant (14) dans le profil plat (33),
et que l'orifice traversant (14) partage le segment (13) de tige en deux branches (11, 12) en amorti réciproque dans le plan du profil plat (33) et qui lors d'un enfichage brident la tige (15) dans le trou (53) de la plaque (50),
**caractérisé en ce que**
les deux branches (11, 12) sont configurées différemment l'une de l'autre, **en ce qu'**une branche (11) présente un plus long tracé longitudinal (21) que l'autre (12) et que donc ce segment (13) de tige se compose d'une branche longue (11) et d'une branche courte (12),
et **en ce que** l'extrémité (20) de tige possède une tête (40) contre-dépouillée qui lorsque enfichée pénètre derrière une arête (57) - limitant le trou (53) - de la plaque (50).

2. Connecteur enfichable selon la revendication 1, **caractérisé en ce que** la branche longue (11) est coudée tandis que la branche courte (12) présente un tracé essentiellement étiré.

3. Connecteur enfichable selon la revendication 1 ou 2, **caractérisé en ce que** la branche longue (11) présente un tracé en S.

4. Connecteur enfichable selon l'une des revendications 1 à 3, **caractérisé en ce que** l'orifice traversant (14) situé entre les deux branches (11, 12) est configuré asymétrique et qu'il suit l'incurvation de la branche longue (11).

5. Connecteur enfichable selon l'une des revendications 1 à 4, **caractérisé en ce qu'**au repos déjà, c'est-à-dire lorsque le connecteur enfichable (10) est démonté, l'orifice traversant (14) présente un rétrécissement (47) dans sa zone médiane (45)
et **en ce qu'**en partant du rétrécissement (47), l'orifice traversant (14) possède des zones terminales (44, 46) élargies aux deux extrémités, c'est-à-dire aussi bien en direction de la tête (40) qu'en direction du composant (30).

6. Connecteur enfichable selon la revendication 5, **caractérisé en ce que** la zone terminale (44) supérieure part de l'orifice traversant (14) pour s'étendre jusqu'à l'intérieur du composant (30) en passant par les zones en saillie (26, 27) des deux branches (11, 12).

7. Connecteur enfichable selon les revendications 4 à 6, **caractérisé en ce que** la zone (46) située en dessous du rétrécissement (47) du passage traversant (14) suit pour l'essentiel le tracé incurvé de la branche longue (11).

8. Connecteur enfichable selon l'une des revendications 1 à 7, **caractérisé en ce que** la branche courte (12) possède une branche (28) élargie configurée pour dépasser la largeur (48) de la branche et qui rigidifie la branche courte (12).

9. Connecteur enfichable selon la revendication 8, **caractérisé en ce qu'**entre la branche (28) élargie et la tête (40) à l'extrémité (20) de tige a été agencée une partie terminale (55) d'une largeur inférieure à la largeur (58) de branche.

10. Connecteur enfichable selon la revendication 9, **caractérisé en ce que** lors de la transition entre l'état de repos et l'état enfiché, la pièce terminale (55) de branche sert de zone de flexion pour la tête (40) située à l'extrémité (20) de tige.

11. Connecteur enfichable selon l'une des revendications 1 à 10, **caractérisé en ce que** la branche longue (11) présente une largeur (49) de branche pour l'essentiel constante, mais qu'elle possède une extrémité étroite (56) de branche dans la zone de transition vers la tête terminale (40).

12. Connecteur enfichable selon la revendication 11, **caractérisé en ce que** dans la zone de transition entre l'état de repos et l'état enfiché, l'extrémité (56) étroite de la branche longue (11) sert aussi de zone de flexion à la tête terminale (40).

13. Connecteur enfichable selon l'une des revendications 1 à 12, **caractérisé en ce que** - observé à l'état de repos - une contre-dépouille (42, 41) est prévue contre la tête
terminale (40) de la tige (15) non seulement sur la branche courte (12) mais aussi sur la branche longue (11).

14. Connecteur enfichable selon la revendication 12, **caractérisé en ce que** la contre-dépouille (41) de la tête (40) contre la branche longue (11) présente à l'état enfiché un tracé plus étiré qu'à l'état de repos.

15. Connecteur enfichable selon l'une des revendications 1 à 14, **caractérisé en ce que** le composant est un moyen de fixation (35) affecté à une pièce de fonction (60) qui en est séparée.
